(19) **Europäisches Patentamt**

**European Patent Office**

**Office européen des brevets**

(11) **EP 1 087 478 A1**

(12) **EUROPEAN PATENT APPLICATION**

(43) Date of publication:
**28.03.2001 Bulletin 2001/13**

(51) Int. Cl.[7]: **H01S 5/12**, H01S 5/10

(21) Application number: **00202152.5**

(22) Date of filing: **21.06.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **27.09.1999 US 405119**

(71) Applicant:
**Nortel Networks Limited
Montreal, Quebec H2Y 3Y4 (CA)**

(72) Inventors:
- **Hui, R.Rongqing
  Lenexa, Kansas 66219 (US)**
- **Hong, J Jin
  Cupertino, California 95014 (US)**
- **O'Sullivan, S Maurice
  Ottawa, Ontario K1Y 0S5 (CA)**

(74) Representative:
**Ertl, Nicholas Justin et al
Elkington and Fife,
Prospect House,
8 Pembroke Road
Sevenoaks, Kent TN13 1XR (GB)**

(54) **Generation of short optical pulses using strongly complex coupled DFB lasers.**

(57) A compact source capable of generating continuously tunable high frequency microwave radiation and short optical pulses in the picosecond/sub-picosecond range is invented. It includes a laser structure having two lasers formed on the same substrate which simultaneously operate at different longitudinal modes. Each laser has a complex coupled (gain-coupled or loss-coupled) grating which is formed by deep etching through a multi-quantum well structure, either of the active medium or of the additional lossy quantum-well layers, thus ensuring no substantial interaction between lasers. The lasers have a common active medium and shared optical path and provide mutual light injection into each other which results in generation of a beat signal at a difference frequency of two lasers. The beat frequency is defined by spacing between the laser modes and may be continuously tuned by current injection and/or temperature variation. Thus, the beat signal provides a continuously tunable microwave radiation. To form a train of short optical pulses, the beat signal is either further sent to a saturable absorber followed by a semiconductor optical amplifier, or sent directly into an optical compressor which includes a dispersion fiber. As a result, a duration of each impulse is compressed, and a train of short optical pulses is formed. An embodiment of the invention, where *N* short pulse optical trains, each at frequency *f*, are combined so as to interleave and form one short pulse optical train at frequency *Nf*, is also provided.

FIG. 2

**EP 1 087 478 A1**

**Description**

**FIELD OF INVENTION**

This application relates to U.S. Patent Application Serial No. 09/213,088 filed on December 15, 1998; to U.S. Patent Application Serial No. 09/405,119 filed on September 27, 1999; and to PCT Patent Application Serial No. PCT/CA99/00126 filed on November 25, 1999. The invention relates to generation of short optical pulses with particular application to transmission of data.

**BACKGROUND OF THE INVENTION**

Ultra high speed time domain multiplexing (TDM) optical transmission systems in optical fibers require compact light emitting sources capable of generating optical short pulse trains in a picosecond/sub-picosecond range. General requirements for short pulse sources such as soliton sources are narrow pulse width, low time jitter and a continuously tunable repetition rate. For practical fiber optic systems, there are additional requirements of long-term reliability, small size and easy data encoding in the system application.

There are several known methods to generate short optical pulse trains. Complicated passive or active mode locking techniques are available for high speed optical pulse generation where pulses are generated at a fixed repetition rate determined by the roundtrip time of the laser resonator, e.g. D. J. Derickson et al., "Short pulse generation using multisegment mode-locked semiconductor lasers," IEEE J. Quantum Electron., Vol. 28, pp. 2186-2202, 1992. These techniques are sensitive to phase matching conditions and therefore difficult to build and maintain. Another method is gain switching of lasers which suffer from high time jitter. Pulse generation at repetition rates over 50 GHz is extremely difficult to achieve in this method because of limitations of the device modulation bandwidth and radio frequency supply as described, e.g. in publication by A. G. Weber, W. Ronghan, E. H. Bottcher, M. Schell and D. Bimberg, "Measurement and simulation of the turn-on delay time jitter in gain-switched semiconductor lasers," IEEE J. Quantum Electron., Vol. 28, pp. 441-445, 1992.

High repetition rate optical pulses can also be generated using a dual wavelength light source as described, e.g. in publication P. V. Mamyshev, S. V. Chernikov and E. M. Dianov, "Generation of Fundamental soliton trains for high-bit-rate optical fiber communication lines," IEEE J. Quantum Electron., vol. 27, pp. 2347-2355, 1991. Two wavelengths emitted by two lasers are mixed to form a high frequency sinusoidal signal which is sent though an optical combiner and optical amplifier followed by a nonlinear fiber. As a result the sinusoidal signal is compressed into a train of optical pulses. The common approach of dual wavelength light sources is to use two discrete lasers, which is complex and suffers from the long term stability issue. Dual wavelength operation can also be accomplished by selecting the appropriate phase modulation sidebands from an externally phase modulated light source, e.g. P. V. Mamyshev, "Dual-wavelength source of high-repetition-rate, transform-limited optical pulses for soliton transmission" Opt. Lett., Vol. 19, pp. 2074-2076, 1994. This method requires high frequency modulation and optical filters. In order to make this method more practical two solitary laser diodes are usually used to generate the sinusoidal beat signal. Unfortunately, frequency variations of each laser are subject to both thermal and mechanical fluctuations which result in beat signal frequency fluctuations. Phase noise of both lasers also contribute to the jitter of the beat signal significantly. The control of the polarization from each laser output and the effort to align and maintain them is also a practical issue that decreases the system performance. Therefore, the resulting signal performance is not satisfactory and practical use of such a configuration in commercial ultra high speed applications is in question.

Additionally, although dual-mode lasers are capable of generating ultra-high beat frequencies of up to several THz, a major challenge is how to encode information data into the optical train. Up to date, the most reliable way of encoding data into fiber optics systems is to use high speed modulators, with electro-optic (EO) modulators being the most common choice. However, the maximum modulation bandwidth of state-of-the-art electro-optic modulators is currently limited to approximately 50Gb/s. It means that soliton trains having higher repetition rates can not be handled by existing types of modulators. As a result, the speed of data transmission is unavoidably limited, restricting performance of optical transmission systems.

Accordingly, there is a need in the industry for a practical, compact and reliable optical source of continuously tuning high repetition rate short optical pulses which is suitable for optical transmission systems and high speed optical signal processing.

**SUMMARY OF THE INVENTION**

It is an object of the present invention to provide an optical pulse source which avoids the afore-mentioned problems.

Thus, according to one aspect of the present invention there is provided an optical pulse source, comprising:

　　a first single mode DFB semiconductor laser having a first grating for generating light at a first frequency;
　　a second single mode DFB semiconductor laser having a second grating for generating light at a second frequency;
　　the lasers having a common active medium and shared optical path, the lasers providing mutual light injection into each other resulting in generation of a beat signal at a difference frequency of two lasers;

an optical compressor disposed to receive the beat signal and compressing the pulse duration of the signal, thus forming a train of short optical pulses having a pre-determined duration and a repetition rate.

The source may further include a saturable absorber disposed to receive the beat signal before it is sent to the optical compressor. The absorber provides an initial time compression of the signal, thus transforming the beat signal into an initial train of optical pulses. Additionally, an optical amplifier may be used for amplification the beat signal or the initial train of pulses, e.g. including an erbium doped fiber. The optical compressor may include a dispersion decreasing fiber, a dispersion shifted fiber and/or an external erbium doped fiber amplifier. The source may further include means for data encoding into the train of short pulses, e.g. an optical modulator operating at a speed determined by the repetition rate. A typical range of the repetition rates is from about several tens GHz to about several hundred GHz with a sub-range from about 25 GHz to about 80 GHz being of special importance for data transmission. A typical duration of pulses in the pulse train is within a picosecond/sub-picosecond range.

A source includes a dual mode laser which has two gain coupled DFB lasers, or alternatively it may include loss coupled DFB lasers. Preferably, the active medium of the lasers includes a multiple quantum well structure. Advantageously, the first and second gratings in the first and second lasers are formed by etching grooves directly through the multiple quantum well structure. Beneficially, each grating has a period comprising a first section and a second section with substantially all quantum wells being etched away from the second section, thus providing no substantial photon emission in the second section and ensuring no substantial interaction between the lasers. A source may further have means for stabilizing the frequency of one of the first and second lasers, or means for stabilizing frequencies of both lasers. Means for tuning frequencies of the first and second lasers may be provided additionally. To ensure reliable and accurate mode, low frequency modulation of light generated by one of the first and second lasers, may be provided. Alternatively, light generated by the lasers may be modulated simultaneously. Beneficially, the modulation is provided at a frequency which is subharmonic to the beat frequency.

In the first embodiment a source includes first and second gratings which have same periods, and it is arranged that lasers generate light at the different sides of stopband.

In the second embodiment a source includes first and second gratings which have same periods, and it is arranged that lasers generate light at the same side of stopband. The difference between the first and second frequencies is provided by different current injection into the first and second lasers, or by difference in temperature control of the first and second lasers. Alternatively it may be provided by different width of the active medium in the first and second lasers.

In the third embodiment a source includes the first and second gratings which have different periods. It is arranged that the frequency of one of the lasers which is remote from an output facet does not fall within a stopband of the other laser which is closer to the output facet so that light emitted by the remote laser can pass through the shared optical path to the output facet.

In the fourth embodiment, instead of pumping the active medium of the source by current injection in to the active medium, the pumping is provided by an external optical pumping source.

In modifications to the embodiments described above, a source may include the first and second gratings which are either uniform or chirped, the gratings preferably being first order gratings which are formed by holographic techniques or electron beam writing onto the active medium.

According to another aspect of the invention there is provided an optical pulse source, comprising:

a first single mode DFB semiconductor laser having a first grating for generating light at a first frequency;

a second single mode DFB semiconductor laser having a second grating for generating light at a second frequency;

the lasers having a common active medium and shared optical path, the lasers providing light injection of light into each other resulting in generation of a beat signal at a difference frequency of two lasers;

a saturable absorber disposed to receive the beat signal and providing an initial time compression thus transforming the beat signal into an initial train of optical pulses;

an optical amplifier disposed to receive the initial pulse train after the absorber;

an optical compressor disposed to receive the pulse train after the optical amplifier and compressing duration of pulses of the train, thus forming a train of short optical pulses having a pre-determined duration and a repetition rate,

the first and second lasers, the saturable absorber and the optical amplifier being formed on the same chip.

Conveniently, the lasers, the saturable absorber and the optical amplifier are integrated within a package.

According to yet another aspect of the invention there is provided a source of radiation, comprising:

a first single mode DFB semiconductor laser having a first grating for generating light at a first frequency;
a second single mode DFB semiconductor laser having a second grating for generating light at a second frequency;
the lasers having a common active medium and shared optical path and providing mutual light injection into each other resulting in generation of radiation at a beat frequency of two lasers.

Preferably, the source of radiation includes either gain coupled DFB lasers or loss coupled DFB lasers with the active medium comprising a multiple quantum well structure. Advantageously, the first and second gratings are formed by etching grooves directly through the multiple quantum well structure. To provide no substantial interaction between two lasers, it is arranged that each grating has a period comprising a first section and a second section with substantially all quantum wells being etched away from the second section, thus providing no substantial photon emission in the second section. A typical wavelength range of the radiation generated by the source corresponds to microwave to millimeter wavelength range.

Conveniently, the first and second gratings have same periods, and it is arranged that the first and second lasers generate light at the same side of stopband. The difference between the first and second laser frequencies may be provided by different current injection into the first and second lasers, by different width of the active medium in the first and second lasers and/or by difference in temperature control of the first and second lasers.

Alternatively, a source of radiation may include gratings having same periods while the first and second lasers generate light at different sides of stopband.

In yet another alternative a source may include the first and second gratings having different periods. It is also provided that the frequency of one of the lasers which is remote from an output facet does not fall within a stopband of the other laser which is closer to the output facet so that light emitted by the remote laser can pass through the shared optical path to the output facet. Conveniently, the source may further include means for modulation of light generated by one of the first and second lasers at a frequency which is subharmonic to the beat frequency. Advantageously, the source is formed on a chip and integrated within a package.

According to yet another aspect of the invention there is provided a source of short pulse optical train of frequency $Nf$, comprising:

means for forming $N$ short pulse optical trains, each of frequency $f$, carrying encoded data;
means for providing phase shifts between said $N$ trains so as, when the trains are combined, to form one combined optical pulse train of frequency $Nf$;
means for combining said $N$ trains into said combined optical train.

Beneficially, the source comprises $N$ data encoding branches, each branch including:

a dual mode laser generating a signal at frequency $f$ defined by the beat frequency between the dual modes;
an optical compressor disposed to receive the laser signal and to compress the duration thereof to form the short pulse train; and
encoding means for providing that required data is encoded into the train.

Advantageously, the means for providing phase shifts between said $N$ trains comprises:

means for subharmonic modulation of each laser at frequency $f/n$, wherein $n$ is an integer, to provide phase locking;
variable delay lines disposed to introduce said phase shifts between the signals.

Additionally, the means for providing phase shifts further comprises a feedback means for sending control signals to the variable delay lines to adjust the phase shifts so as to ensure that $N$ optical trains interleave in a precise timing.

Beneficially, the dual mode laser comprises first and second DFB lasers, each laser including one of the gain coupled and loss coupled DFB lasers. The first and second lasers have common active medium, shared optical path and provide mutual light injection into each other, and the active medium of DFB lasers includes a multiple quantum well structure. Advantageously, the first and second lasers include first and second gratings correspondingly, the gratings being formed by etching grooves directly through the multiple quantum well structure. Conveniently, each grating has a period comprising a first section and a second section, with substantially all quantum wells being etched away from the second section, thus providing no substantial photon emission in the second portion and ensuring no substantial interaction between the lasers.

The encoding means for the source of optical pulse train comprises an electro-optical modulator, e.g. Mach-Zehnder modulator or traveling wave modulator.

The source of a short pulse optical train may include the required number of laser branches, e.g. two, three, four to ten, or any other reasonable number of lasers capable of being combined into one optical train at a required accuracy.

According to yet another aspect of the invention there is provided a method for encoding data into high speed optical train, comprising the steps of:

forming $N$ short pulse optical trains, each of frequency $f$, carrying encoded data;
providing phase shifts between said $N$ trains so as, when the trains are combined, to form one combined optical pulse train of frequency $Nf$;
combining said $N$ trains into said combined optical train.

Preferably, the step of forming $N$ short pulse trains comprises the step of forming each of the trains which includes:

providing a dual mode laser generating a signal at frequency $f$ defined by the beat frequency between the dual modes;
compressing the signal in the optical compressor to form the short pulse train; and
providing that required data is encoded into the train.

Advantageously, the step of providing phase shifts between the $N$ trains comprises:

modulating each laser at frequency $f/n$, which is subharmonic to the beat frequency, to provide phase locking;
forming variable delay lines disposed to introduce said phase shifts between the signals.

## BRIEF DESCRIPTION OF THE DRAWINGS

The invention will now be described in greater detail regarding the attached drawings in which:

Fig. 1 shows a schematic view of a prior art optical pulse source;
Fig. 2 shows a schematic cross sectional view of an optical pulse source according to a first embodiment of the invention;
Fig. 3 shows a detailed cross sectional view of the laser structure of the source of Fig. 2;
Fig. 4 shows a schematic perspective view of the laser structure of the source of Fig. 2;
Figure 5 shows a dual-wavelength operation of the laser structure of the source of Fig. 2;
Figure 6 shows an autocorrelation trace of a beat signal obtained from the dual-wavelength operation illustrated in Fig. 5;
Figure 7 is a schematic view of an optical pulse source according to a second embodiment of the invention;
Figure 8 shows a continuously tunable optical spectrum of the laser structure of the source of dual wavelength operation in Figure 7 where both the absorber and the SOA are not present in the demonstration device;
Figure 9 shows a dual-wavelength operation of the laser structure of the source of Fig. 7 corresponding to a beat frequency 50 GHz;
Figure 10 shows an autocorrelation trace of a beat signal obtained from the dual-wavelength operation illustrated in Fig. 9;
Figure 11 shows an output optical spectrum after pulse compression for an input signal of Fig. 9;
Figure 12 shows an autocorrelation trace of an optical pulse train after pulse compression for the input spectrum of Fig. 9 and the output spectrum of Fig. 11;
Figure 13 shows an autocorrelation trace of an optical pulse train after pulse compression corresponding to a beat frequency of 25 GHz;
Figure 14 shows an autocorrelation trace of an optical pulse train after pulse compression corresponding to a beat frequency of 70 GHz;
Figure 15 is a schematic view of an optical pulse source according to a third embodiment of the invention;
Figure 16 shows a dual-wavelength operation of the laser structure of the source of Fig. 15;
Figure 17 is a schematic view of an optical pulse source according to a fourth embodiment of the invention;
Figure 18 shows a block diagram of a source of an short pulse optical train according to a fifth embodiment of the invention;
Figure 19 shows a continuously tunable optical spectrum of a dual mode laser incorporated into the source of Figure 18;
Figure 20 shows an electrical beat spectrum around 20 GHz for the laser incorporated into the source of Figure 18 in the absence of sub-harmonic injection locking;
Figure 21 shows a signal of laser of Figure 20 which is optically injection locked by the fourth harmonic of a sinusoidal modulation at 5 GHz;
Figure 22 shows a composite electrical spectrum including the fundamental frequency and harmonics for the dual mode laser incorporated into the source of Figure 18;
and
Figure 23 shows a time domain waveform for the laser incorporated into the source of Figure 18 with the fourth harmonic injection locking.

## DESCRIPTION OF PREFERRED EMBODIMENTS

STRUCTURE AND OPERATION

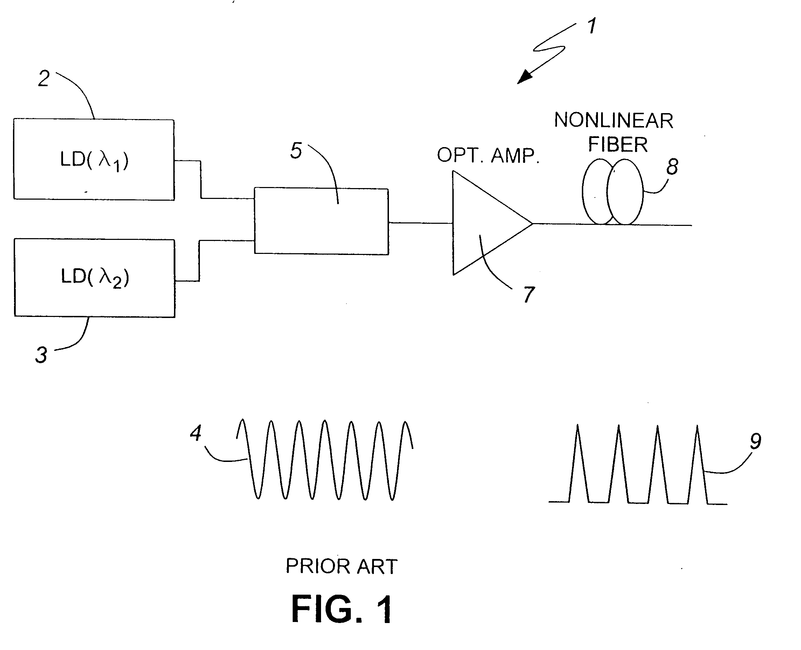

The prior optical pulse source **1** is schematically shown in Figure 1. Light generated at first and second wavelengths $\lambda_1$ and $\lambda_2$ by first and second lasers **2** and **3** is mixed to form a high frequency sinusoidal signal **4** at difference beat frequency. The beat signal is further sent though an optical combiner **5** and optical amplifier **7** followed by a nonlinear fiber **8** where the initial pulse is amplified, chirped and then compressed by the nonlinear Kerr effect. As a result, the sinusoidal signal **4** is compressed into a train of optical pulses **9** as illustrated in Fig. 1.

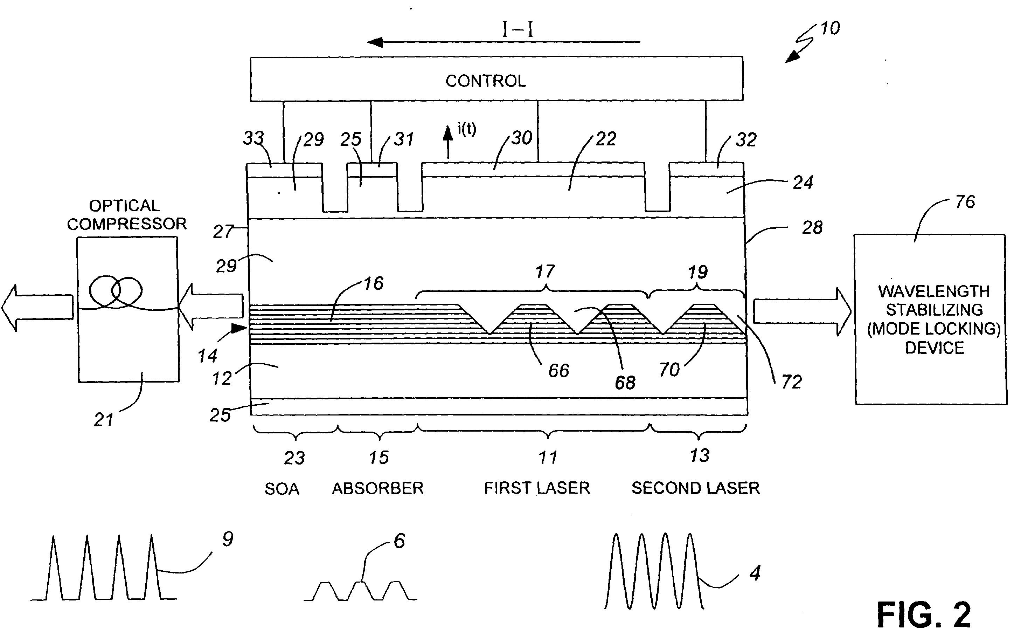

A schematic cross section through a source of short optical pulses **10** according to a first embodiment of the present invention is shown in Figure 2. The source **10** comprises dual mode laser including a first gain coupled DFB laser **11** and a second gain coupled DFB laser **13** having their cavities arranged coaxially along same optical axis, designated by a numeral I-I in Figure 1. Lasers **11** and **13** have outputs arranged along the line I-I and in the same direction shown by an arrow on the line I-I, the first laser **11** being closer to an output facet **27**. The source **10** is formed on a substrate **12** providing a first confinement region, an active medium **14** comprising a multiple quantum well structure **16** and a first and second uniform gratings **17** and **19** defined therein, and an overlying confinement region **20**. Means for excitation the first and second lasers are formed thereon, and include a contact to the substrate **26**, first and second current confining ridges **22** and **24,** first and second contact electrodes **30** and **32** being defined on each ridge respectively for current injection into the laser structure. The first and second gratings **17** and **19** positionally correspond to the first and second lasers **11** and **13** respectively. The gratings have same grating periods, and lasers **11** and **13** have different length so that they will behave differently in lasing operation. For example, in the device shown in Fig. 2, the first section is 150 micrometers long and the second section is 550 micrometers long. The lasers provide a dual wavelength operation, i.e. each laser provides a stable generation at its own frequency/wavelength in the presence of another laser. In the first embodiment it is arranged that lasers **11** and **13** generate at different sides of a DFB stopband, e.g. the laser **11** generates at the left Bragg mode of the stopband, while the laser **13** generates at the right Bragg mode of the stopband. Therefore the wavelength/frequency spacing of the lasers is determined by the stopband width. The lasers **11** and **13** have a common active medium **14** and shared optical path to the output facet **27** and provide mutual injection of light into each other. Due to mutual injection of light into each other, a sinusoidal optical beat signal is generated by the lasers, with the frequency spacing defined by the wavelength spacing between the two stable operated modes. The frequency spacing is fine tuned to the specific frequency spacing required in the system by current injection into the lasers **11** and **13**. The beat signal is a source of tunable radiation having a typical wavelength within a microwave to millimeter range.

Both gratings **17** and **19** are made by periodic etching grooves through the active medium **14**, the depth of etching being defined so as to provide a substantial insensitivity of each laser to the external feedback and random facet variations and thereby ensuring no substantial interaction between lasers in the series as will be also described in detail below. An additional short section of a reversely biased saturable absorber **15** and a semiconductor optical amplifier (SOA) **23**, both with no grating written onto the active medium, are added on the same chip. By doing so, all the sections are naturally aligned and the polarization state is maintained through the device. Means for current injection into the absorber **15** and amplifier **23** sections are formed similar to that of the laser excitation means described above and include current confining ridges **25** and **29** respectively, with corresponding contact electrodes **31** and **33** being defined on each ridge as shown in Fig. 2. As illustrated in Fig. 2, the beat signal **4** is received by the saturable absorber 15 which provides a partial initial compression of pulse duration and forms an initial optical pulse train **6** which is amplified by SOA **23**. Then the initial optical pulse train **6** is further compressed by an optical compressor **21** including dispersion fiber in such a way that the initial amplified train is transformed into a train of short optical pulses **9** having a pre-determined duration and a repetition rate. The resulting short optical pulse train **9** is further data encoded with a high speed external optical modulator (not shown), which operates at a speed of the frequency spacing determined by the wavelength spacing in the lasers **11** and **13**. Optionally, light generated by one or two lasers is modulated at a frequency which is subharmonic to the beat frequency, and/or frequencies of one or both lasers are stabilized by a wavelength locking device.

The beat signal **4** may be sent directly to the optical compressor **21,** where the initial pulse is amplified, chirped and then compressed by the nonlinear Kerr effect. Therefore an internal (e.g. SOA **23**) or additional optical amplifier is required to amplify the signal before it is compressed. The saturable absorber **15** is used to provide an initial pulse compression and thus to reduce requirements to the optical compressor, e.g. to use shorter lengths of dispersion shifted fiber or dispersion decreasing fiber.

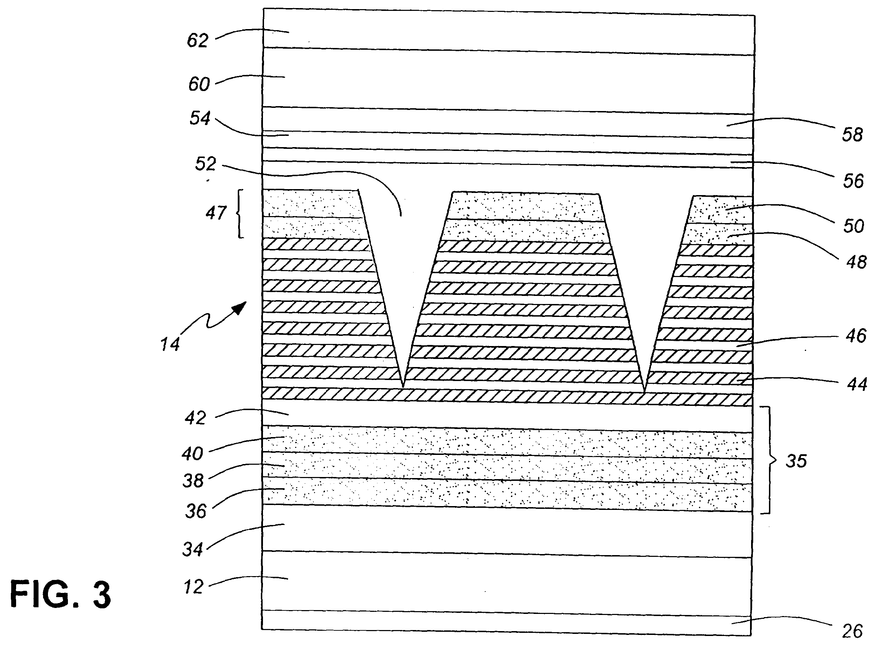

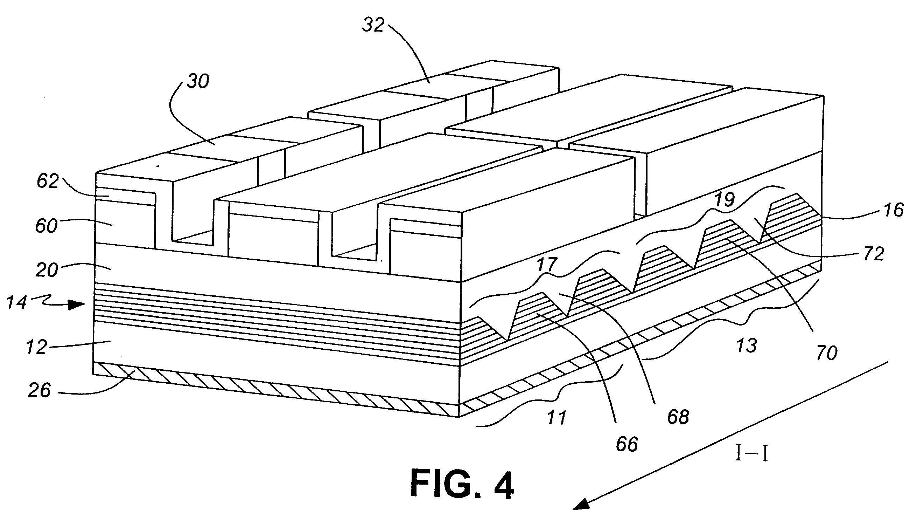

The structure of the lasers **11** and **13** forming the source **10** is shown in more detail in Figure 3, which illustrates an oblique cross-sectional view through the laser part of the source structure **10**, and Figure 4 which shows a perspective view of the source **10**. The DFB semiconductor laser source **10** is fabricated from Group III-V semiconductor materials, and comprises a heavily N-doped InP substrate **12**, on which an N-doped InP buffer layer **34** of 1.5 μm thickness is defined. The first separate confinement region **35**, consisting of four confinement layers **36, 38, 40** and **42** of N-doped InGaAsP with energy band gaps corresponding to wavelengths of 1.0 μm, 1.1 μm, 1.15 μm and 1.20 μm respectively, is provided over the buffer layer **34**. The thickness of each confinement layer is 20 nm, and the confinement layer

36 corresponding to the 1.0 μm wavelength is adjacent to the buffer layer 34. The active region 14 overlies the confinement region 35 and comprises a multiple quantum well (MQW) structure 16 which includes four to eight 1% compressively strained N-doped, or undoped InGaAsP quantum wells 44, each being 5 nm thick, separated by several undoped or P-doped InGaAsP unstrained barriers 46 with a band gap corresponding to wavelength of 1.20 μm, each barrier being 10 nm thick. The alloy composition and layer thickness of the MQW structure 16 are tailored to have specific band gap energies to provide for lasing at a required wavelength. Increasing the number of quantum wells provides higher gain per unit length of the laser cavity. The band gap of the quantum well structure described above provides a lasing wavelength of the device at about 1.55 μm. A second separate confinement region 47, consisting of two P-doped InGaAsP confinement layers 48 and 50, having energy band gaps corresponding to 1.1 μm and 1.20 μm wavelengths respectively, is grown on top of the MQW active region 14, each layer being 20 nm thick.

As mentioned above, gratings 17 and 19 are defined by periodically etched grooves through the active medium 14. The pitch of the groove of each grating is selected so as to define a first order grating for the lasing Bragg wavelength. Grating 17 has a period comprising a first section 66 and a second section 68 as shown in Figures 2 and 4. Grating 19 has corresponding first and second sections 70 and 72. Second sections 68 and 72 in the respective gratings 17 and 19 are V-shaped and characterized by substantial etching away almost all quantum wells, namely, seven out of eight quantum wells in this embodiment. The more quantum wells are etched away from the section the less is the photon generation in the section. Thus, a deep etching through the second sections 68 and 72 provides no substantial photon emission in these sections. Usually deep etching is avoided for a single laser because of the accompanied strong index coupling. For the series of DFB lasers, deep etching provides substantially independent generation of each laser in the series and no substantial interaction between lasers as will be described below.

A P-doped InP layer 52, fills the grooves of the gratings. A 3 nm thick etch stop layer 54 of P-doped InGaAsP, surrounded by P-doped InP buffer layer 56 at the bottom and P-doped InP buffer layer 58 at the top is formed next, the buffer layers being 100 nm and 200 nm thick correspondingly. An upper cladding layer 60 of P-type InP, followed by a highly doped P-type capping layer 62 of InGaAs for contact enhancement, having thickness 1600 nm and 200 nm correspondingly, complete the structure. The separation between the adjacent electrodes 30 and 32 is in the range of 5 to 15 μm to ensure both a sufficient electrical isolation between the adjacent electrodes and a limited material absorption loss. A bottom electrical N-contact 26 is provided at the bottom of the substrate 12. Corresponding means (not shown) for simultaneous two-wavelength generation of the lasers 11 and 13, means for controllably varying current injection and changing temperature of each laser for switching between lasing modes, preferably within a time interval of several nanoseconds, and tuning of laser wavelength of each laser around a corresponding lasing mode are provided.

Thus, a source 10 of short optical pulses and micrometer/millimeter wavelength radiation is provided.

While the source described above is fabricated on a N-type substrate wafer, alternatively, a complimentary structure may be fabricated on a P-type wafer.

The substrate 12 on which the source 10 described above is fabricated is made of InP material which results in generating light by lasers 11 and 13 within a range of 1.3-1.56 μm, corresponding to a transparency window of this material. In modifications of this embodiment, the substrate may be made of GaAs material, having a window of transparency in a shorter wavelength range of 0.8-0.9 μm, which results in generating light in this wavelength range.

In modifications of this embodiment, a source 10 may comprise a first 11 and a second 13 strongly loss coupled DFB lasers, each laser comprising a loss coupling grating 17 and 19 correspondingly, and Bragg modes of the lasers being at different sides of the stopband. Deep etching through the quantum wells of the active regions provides strong loss coupling and independent generation of each laser. Other arrangements of laser wavelengths, providing simultaneous operation of two lasers and ensuring generation of the beat signal, are also possible.

A height and a shape of the first and second sections of gratings periods may also vary to define photon emission in the sections, which, for example, have rectangular or trapezoidal shape. The grating may be formed by either direct electron beam writing, phase mask printing, or double exposures.

An optical amplifier 23 which is built on the same chip as the other sections of the optical pulse source, may be substituted with an additional amplifier, e.g. an external EDFA. Alternatively, both types of amplifiers, may be used simultaneously.

The optical compressor 21 may include a dispersion decreasing fiber as described above, or alternatively, a combination of dispersion shifted fiber and normal single mode fibers.

Principles of operation, demonstrated on the source of DFB lasers 10 of the first embodiment of the invention, are as follows.

It is known that complex coupled lasers provide an additional advantage over index coupled and quarter-wavelength shifted DFB lasers in suppressing one of the two originally degenerated Bragg modes. Both theory and experiment have confirmed that in-phase gain coupled DFB laser will predominantly lase on a longer wavelength side of the stop band (right Bragg mode), while the anti-phase loss coupled DFB laser will predominantly lase on a shorter wavelength side of the stop band (left Bragg mode).

For a gain coupled laser 11 with a grating 17 formed by direct etching through the active region, the second section of the grating period 68 where a portion of quantum wells is etched away, has smaller effective refractive index than the first section of the grating period 66 where the quantum wells are not etched at all. From a standing wave point of view, the first section 66 having higher refractive index, will support a photon emission at the longer wavelength, while the second section 68 having smaller refractive index, will support a photon emission at the shorter wavelength. Since there are more quantum wells in the first section 66 with a higher refractive index section, the emission at the longer wavelength will dominate. Nevertheless, if only a small portion of the quantum wells is etched away from the second section 68 of the grating period, a noticeable photon emission will be still generated in this section. In this case, there will be a chance that laser 11 will generate at the short wavelength (left Bragg mode) as a dominant mode on certain occasions, when a combination of external facet phases or external feedback phases is in favour to the short wavelength, the situation being typical for index coupled lasers. In order to eliminate such an unpredictable combination of phases, in the laser of the embodiment substantially all quantum wells from the second section 68 of the grating period are removed, to ensure that no substantial emission is originally generated in this section. This results in the photon emission in the first section 66 predominantly, and hence, in lasing at the longer wavelength side of the stop band (right Bragg mode) only. The lasing mode of such a laser is therefore determined by an internal built-in and distributed mode selection means, for example, by the grating defined by deep etching rather than by the external facet phase and coating asymmetry. When arranged in a series, each of such lasers, being phase insensitive and providing stable single mode operation under almost all phase combinations, ensures almost independent operation of each laser and no substantial interaction between the adjacent lasers. We have called such a laser a "strongly gain coupled DFB laser" and utilized it as a building block for the source of short optical pulses and microwave radiation 10.

Thus, the lasers 11 and 13 generate a single wavelength light simultaneously, each at its own side of the stopband, and thus produce the beat signal 4 in the microwave to millimeter wave range. As briefly described above, the beat signal 4 is sent to the saturable absorber 15 followed by SOA 23. The length of the absorber 15 is short enough (typically in the range from several tens of micrometers) in order to set a necessary threshold for optical power level. Because of to the difficulty of cleaving it may be technically difficult to create a short section with the precise length at the end of the device. Thus is partially compensated by forming the optical amplifier section 23. The signal after SOA 23 is additionally amplified by an EDFA to 23 dBm and passed through 4.4 km of dispersion shifted fiber followed by 1km normal single mode fiber (not shown). The reason for using dispersion shifted fiber is to generate nonlinear phase modulation. The normal single mode fiber is used to provide an adequate amount of chromatic dispersion to compress the pulse. Alternatively, a 1 to 2 km of dispersion decreasing fiber can be used for pulse compression.

Lengths of different sections are selected so that to make each of the two DFB lasers reasonably long, typically in the range of 150 $\mu$m to 500 $\mu$m depending on coupling grating strength. It ensures that each laser can be viewed as an independent DFB laser with a sufficient immunity to possible external optical feedback and random facet phase variation. The kL value for each laser is preferred to be within 2 to 8 but not limited to this range.

In order to ensure long term stability of one of the lasing wavelengths, e.g. the wavelength generated by the laser 13, a compact and external wavelength locking device 76 is placed in the close proximity of a rear facet 28 of the laser 13 to be locked. A wavelength locking device using Fabry-Perot etalon and described in US Patent 5825792 to Villeneuve (which is incorporated herein by reference) is used. Other known wavelength locking techniques are also applicable.

To ensure reliable and accurate wavelength locking, a different low frequency dithering current, other than the subharmonic modulation signal is applied to the laser 13 on top of the CW bias current in order to dither the output wavelength of the laser. As a result the external wavelength locking device distinguishes the lasing wavelength from the laser 13 and then locks it to greater accuracy without being disturbed by wavelength fluctuations produced by the other laser. In order to further lock two wavelengths with a stable channel spacing and to reduce phase noise and linewidth substantially, a sub-harmonic modulation current $i(t)$ shown in Fig. 2 is applied to the electrode 30 at a frequency $f_m = (f_2 - f_1)/N$. Here $f_m$ is a frequency of the modulation current $i(t)$, $f_1$ and $f_2$ are frequencies of the two lasing modes whose difference is assume to be already tuned to the required beat frequency spacing, and $N$ is an integer.

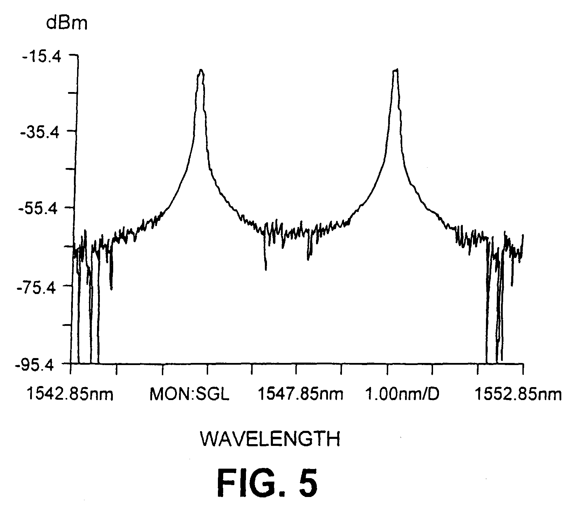

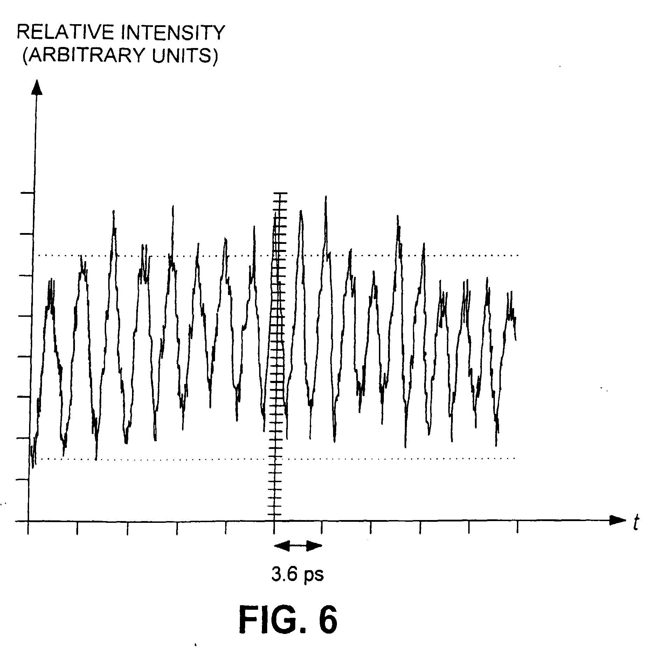

Figure 5 shows a dual wavelength operation gain coupled DFB lasers 11 and 13 with uniform gratings 17 and 19 across the active medium 14 according to the first embodiment of the invention. The dual wavelength operation shown in Fig. 5 exhibits a beat frequency of about 538GHz. It is further illustrated by Fig. 6, where an autocorrelation trace of the beat signal of Fig. 5 is recorded through the second harmonic generation device (an optical autocorrelator). As shown in Fig. 6, a resulting CW signal with a period between maxima/minima roughly equal to 1.9ps is obtained which corresponds to the beat frequency of about 538 GHz. Correspondingly, the laser structure including lasers **11** and **13** can be used as a simple and flexible high frequency (microwave to millimeter wave) generator. A subharmonic injection locking is required to further reduce the linewidth of the high frequency signal and to stabilize the frequency. After passing through the SOA **23**, the signal is additionally amplified by an EDFA to 23 dBm and sent through 4.4 km of dispersion shifted fiber followed by 1km normal single mode fiber (not shown). The resulted compression forms short pulses having a duration of about 1.2 picosecond.

A fine tuning of laser frequencies by current injection and/or temperature variation providing a continuously varying repetition rate for the pulses in the optical train is also provided.

It is worth noting that the dual-mode operation of the lasers mentioned above is fundamentally different from the conventional multi-mode lasers, where modes are competing between each other which is commonly referred to as mode partitioning. In order to verify that there is no competition between the two modes in the lasers, a tunable optical filter was used to select only one mode and sent it into a photodiode (DC - 6GHz). Using an oscilloscope, the optical power fluctuation, if there was any, of the selected mode was observed. The result of the measurement shows that power fluctuations are less than 3%, which might be induced-by current or temperature fluctuations. It proves that mode competition does not exist in the laser structure used in the source **10**.

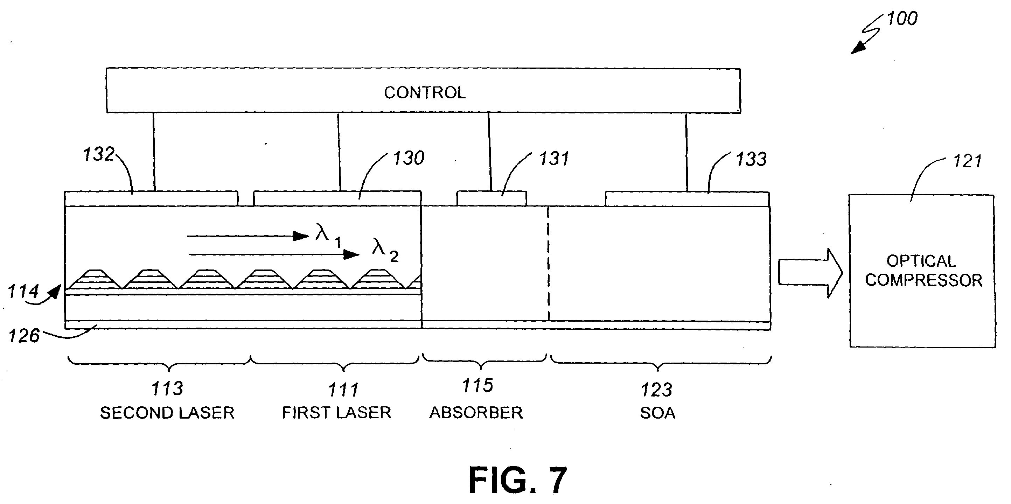

A source **100** of short optical pulses according to a second embodiment of the invention is similar to that of the first embodiment described above except for the lasers **11** and **13** generating at the same side of the stopband and having laser cavities of approximately the same length. As schematically shown in Fig. 7, it includes a first laser **111** generating at a first wavelength $\lambda_1$, and a second laser **113** generating at a second wavelength $\lambda_2$ followed by a saturable absorber **115**, SOA **123** and an optional optical compressor **121** formed on the same chip. The wavelength difference between two lasers is provided by different current injections into the lasers trough corresponding electrodes **130** and **132**. It was chosen that each laser generated at the right Bragg mode (the longer wavelength side of the stopband), and the frequency spacing between lasers was fine tuned by changing injection currents. The source **100** of the second embodiment is especially suitable for a relatively low frequency generation in the range of several tens of GHz, where data encoding can still be handled by existing electro-optic modulators. In practice, there is no limitation for a maximum wavelength separation. However, a minimum wavelength separation is limited by the effect of an optical injection locking as discussed, e.g. in publication by R. Hui, A. D'Ottavi, A. Mecozzi and P. Spano, "Injection locking in distributed-feedback semiconductor lasers."

IEEE J. Quantum Electron., Vol.QE-27, pp.1688, 1991. In order to ensure stable dual wavelength operation and keep away from injection locking between the two wavelengths, the lower limitation of wavelength separation for this embodiment is typically in the order of 20 GHz.

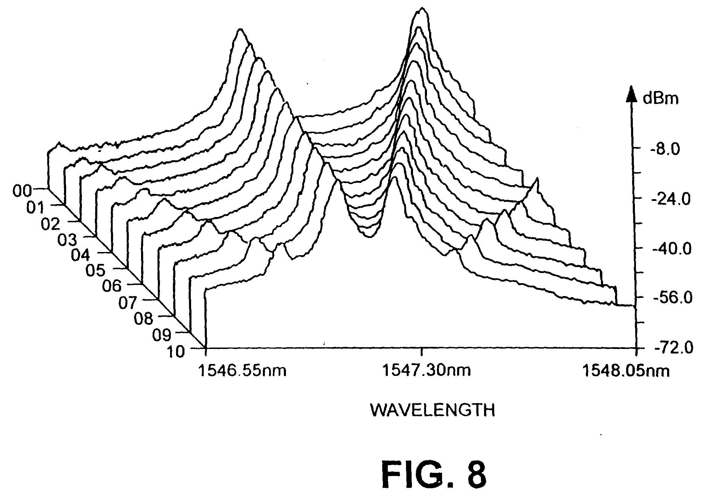

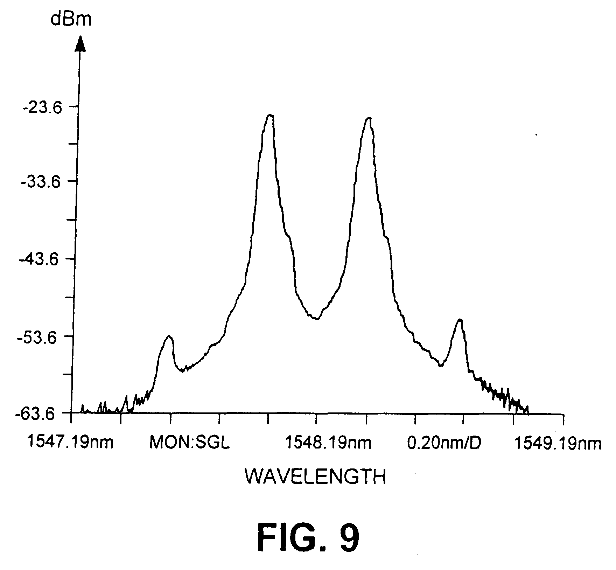

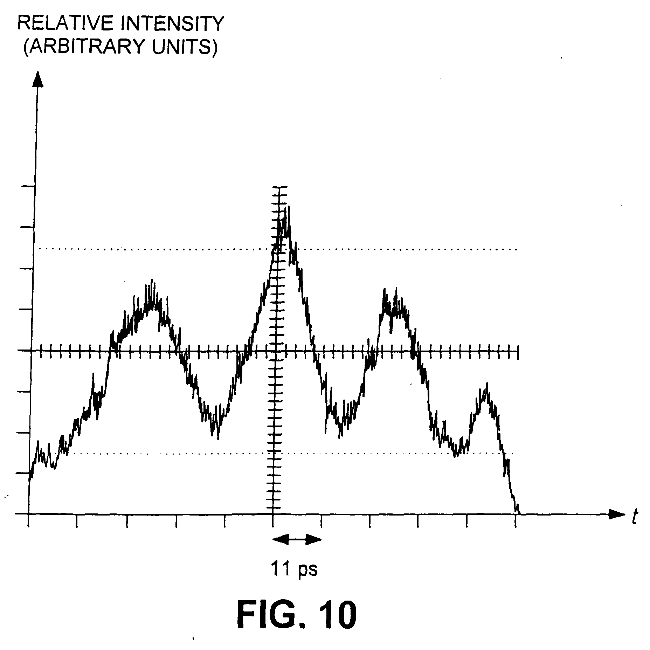

A continuously tunable optical spectrum of the laser structure comprising lasers **111** and **113** of the source **100** is demonstrated in Fig. 8. Since the wavelength spacing can be tuned from 25GHz to 80GHz continuously by current injection alone, a flexibility of generating a CW microwave signal with a tunable frequency can be easily obtained. Figure 9 illustrates a dual wavelength operation of lasers **111** and **113** of the source **100** resulting in generation of microwave radiation with at 50GHz. It is also demonstrated by an optical autocorrelation trace of the 50 GHZ beat signal shown in Fig. 10 which corresponds to a period between peaks of about 20 ps. The two small peaks at each side of the main modes are four-wave mixing side bands. They are created by population pulsation at the beat frequency between the two major stable modes.

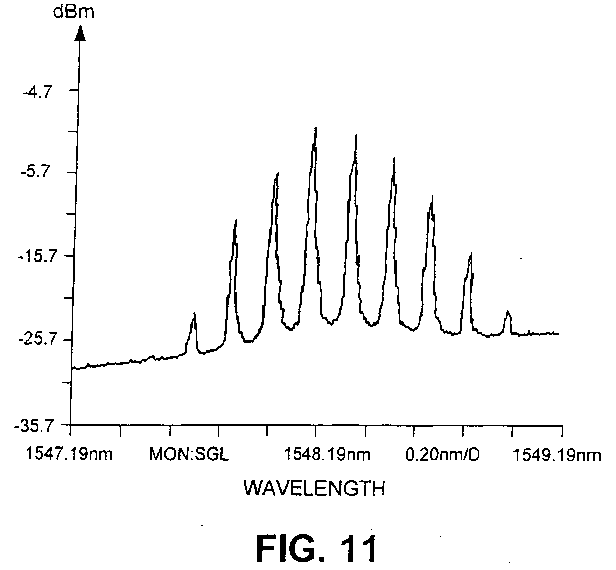

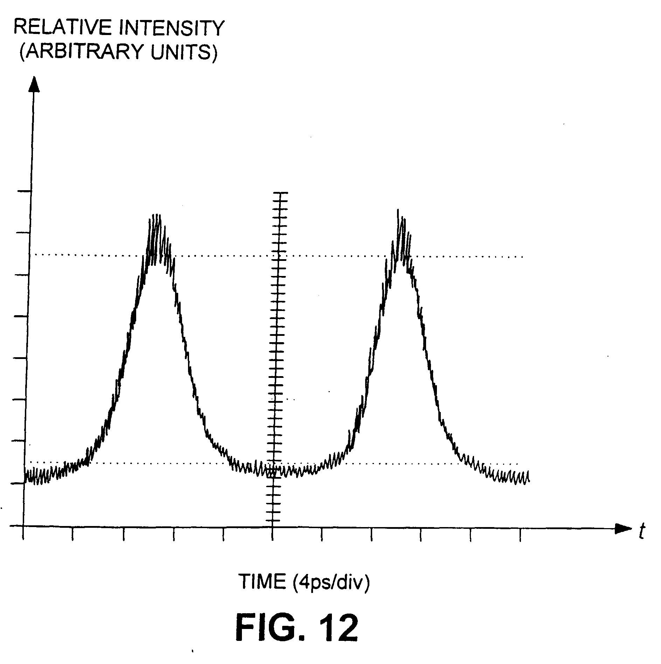

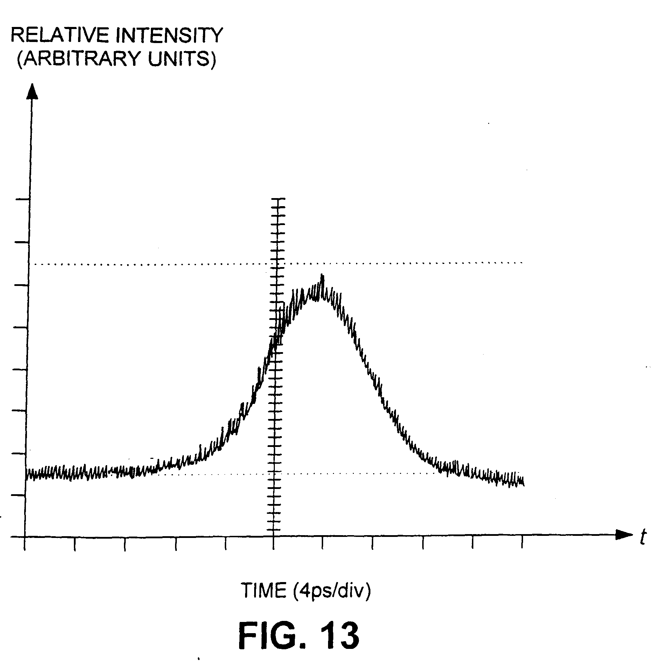

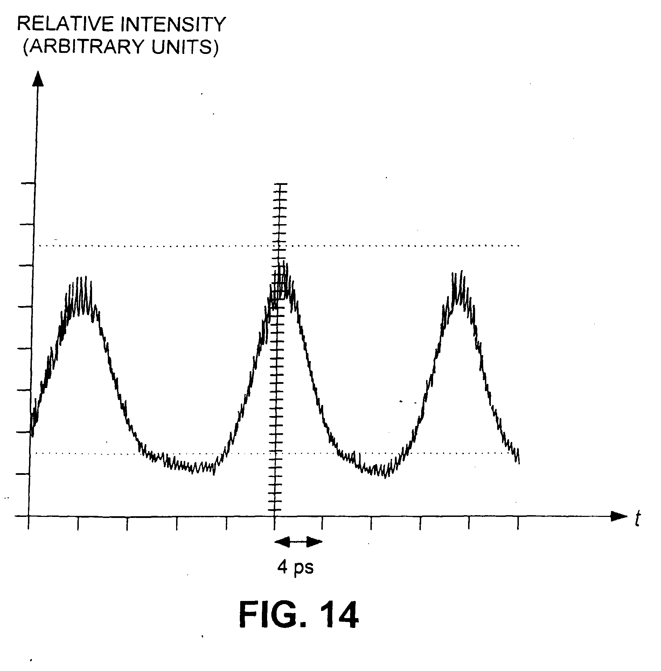

Fig. 11 shows an optical spectrum after the beat signal has traveled through the optical compressor including two fiber sections. It is seen that dual wavelength light shown in Fig. 9 becomes a comb of wavelengths through nonlinear phase modulation process of the nonlinear optical fiber. The corresponding autocorrelation trace (time domain waveform) of the optical train after pulse compression shown in Fig. 12 is measured by an autocorrelator based on second harmonic generation. In this case, the pulse repetition rate is about 50 GHz (about 20 ps separation between pulses), and the pulse duration is approximately 5 ps (FWHM). As illustrated by Fig. 8, the pulse repetition rate can be varied continuously by adjusting the injection current of two lasers. By way of example, time domain waveforms for pulse repetition rates of 25 GHz and 70 GHz are shown in Fig. 13 and 14 respectively. Narrower optical pulses can be obtained by further optimization of the optical compressor parameters, e.g. by selecting precise fiber lengths and using dispersion decreasing fibers.

In modifications to this embodiment the difference between laser frequencies may be provided by difference in temperature control of the lasers. Alternatively, it may be done by fabricating the active medium which has a different width for the first and second lasers, thus providing an effective difference in grating periods. For example, a different width of the laser stripe in ridge waveguide will change an effective modal index and as result will change an effective grating period. Other known techniques providing an effective difference in grating periods are also applicable.

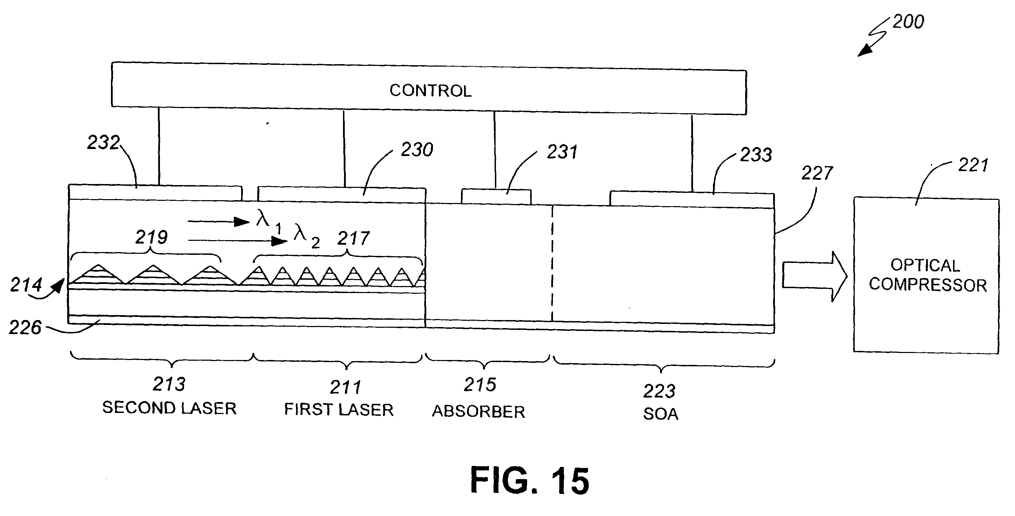

A source **200** of short optical pulses according to a third embodiment of the invention is schematically shown in Fig. 15. This source **200** is similar to that shown in Fig. 7, and like elements are referred to by the same reference numeral incremented by **100**. For example, a first laser **211** and a second laser **213** provide generation at two different wavelengths, the beat signal from which is sent to a saturable absorber **215** and SOA **223** followed by an optical compressor **221**. The source **200** of the second embodiment differs from that of the second embodiment in that, instead of gain-coupled gratings **117** and **119** having same periods as shown in Fig. 7, the gratings **217** and **219** have different grating periods. A center Bragg wavelength separation of the gratings **217** and **219** is equal to 4.8 nm, the first grating **217** having a shorter Bragg wavelength. To provide a path to the output facet **227** for light generated by lasers **211** and **213**, it is necessary to satisfy certain requirements on laser wavelengths and pumping conditions. It is known that when an active region is pumped just above a transparency level (and below a threshold level), a DFB laser becomes transparent for a light passing through if a wavelength of the passing light is outside of the stop band. The same laser becomes lossy and not transparent for the light passing through if the wavelength of the passing light is within the stop band, regardless of the fact that the laser is pumped above the transparency level. Moreover, when the wavelength of the passing light is far enough from the stop band of the laser, it passes through the laser without out substantial interaction even if the laser is pumped above a threshold level and generates a stable lasing mode by itself. Thus, it is arranged that each laser in the source **200** generates at the same side of its stop band, namely at the right Bragg mode, and the Bragg modes of the lasers are arranged in such a way that the lasing wavelength (including intended current and temperature tuning) of the laser **211,** which is closer to the output facet **227** of the source, does not fall within a stop band of the adjacent laser **213,** which is further away from the output facet **227**. It ensures that light generated by more distant laser **213** will pass through the laser **211** which is closer to the series output facet **227**. Lasers **211** and **213** have a common active medium **214** and shared optical path to the output facet **227** and provide mutual injection of light into each other.

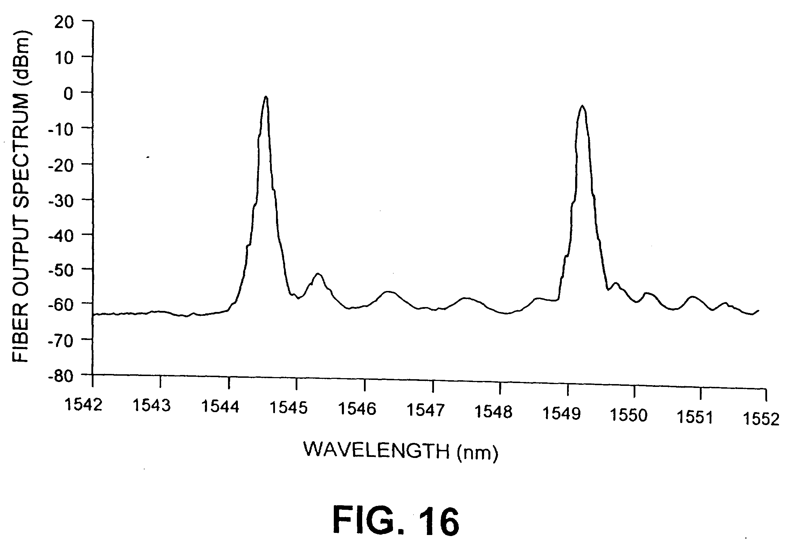

Figure 16 shows a dual wavelength operation of the laser structure of the source **200**. There are clearly seen two stable Bragg modes separated by 4.8 nm from each other in the optical spectrum.

In modifications to this embodiment, the source **200** may comprise a first **211** and a second **213** strongly loss coupled DFB lasers, each laser comprising a loss coupling grating **217** and **219** correspondingly. The gratings will then have periods, defining corresponding laser stop bands and a center Bragg wavelength separation, the first grating **17** having longer Bragg wavelength. It is also arranged that each laser generates at the left Bragg mode around its stop band, and the lasing wavelength of the laser **211,** which is closer to the output facet **227** of the series, does not fall within the stop band of the adjacent laser **213,** which is further away from the output facet **227**. Other arrangements of laser wavelengths providing stable dual wavelength operation of the laser structure of the source **200** are also applicable.

The wavelength spacing between the two modes in this embodiment is determined by a pre-set difference in effective Bragg wavelengths of the two lasers as shown in Fig. 15. When a large wavelength separation is required, e.g. in the case of high repetition rates, a pre-defined wavelength spacing can be set by using gratings with substantially different periods formed through either two different holographic exposures or an electron beam writing in such a way that the two gratings are joined together along the cavity direction. The frequency separation between the two modes, in general, can be designed to meet a large range in the order of several tens of GHz to several thousand GHz. According to the design, the separation can also be fine tuned by current injection and/or temperature variation depending on the system requirement.

In yet other modifications to this embodiment, gratings associated with particular lasers in the source may be either uniform or chirped gratings, and periods of the gratings may vary to provide a predetermined center Bragg wavelength separation (usually within a range of several nanometers to several tens of nanometers) to ensure continuous laser tuning within a certain wavelength range.

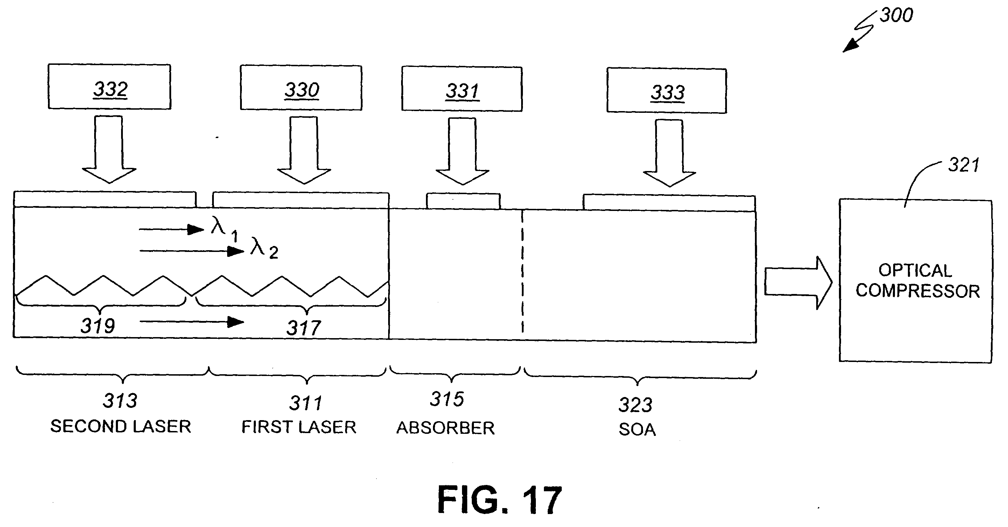

The optical pulse sources of the embodiments described above comprise semiconductor diode lasers, i.e. lasers having contacts for electrical excitation of the active region by current injection. It is also contemplated that a source **300** of a fourth embodiment shown in Fig. 17 may be provided with optical pumping means **330, 332, 331, 333,** replacing corresponding electrical contacts **30, 32, 31** and **33** of the first embodiment (or corresponding electrical contact of the second or third embodiments), e.g. by providing population inversion with suitable optical coupling to another light source on the substrate. The structure and operation of the source **300** is similar to that shown in Fig. 7, and similar elements are referred to by the same reference numeral incremented by **200** respectively.

In modifications to this embodiment, the source **300** may comprise a combination of electrical and optical pumping means, e.g. the lasers **311** and **313** may be pumped optically while the absorber **331** and SOA **323** are pumped electrically by corresponding current injections. Various modifications described above with regards to other embodiments are also applicable to the fourth embodiment, e.g. the source **300** may include gratings having the same periods and provide generation of two wavelengths at different sides of the stopband, or alternatively, it may include gratings having different periods and providing a pre-set wavelength separation. Optionally it may further include a wavelength locking device for stabilizing one or two of generated wavelengths and/or sub-harmonic modulation of one or two lasers.

It is also contemplated that a source of alternative embodiments may comprise buried heterostructure lasers in contrast to the ridge waveguide lasers described in the above embodiments.

The source of optical pulses and microwave radiation described above have advantages over other similar structures which can be summarized as follows.

The source has a compact design due to manufacturing all the components on the same chip. It is capable of generating high frequency microwave and millimeter range radiation and short optical pulses of sub-picosecond to picosecond range with high and yet tunable repetition rate without the use of corresponding high speed electronics. Since wavelength separation of the lasers can be varied within a large range, the optical system, employing such a short pulse generation and data encoding scheme, becomes flexible and versatile. It can also be made easily upgradable to a higher bit-rate system without the need to modify the system architecture. Since the wavelength separation of the dual wavelength lasers is determined by the DFB grating design, there is no practical limitation for the maximum wavelength separation and thus high optical pulse repetition up to tera-hertz can be achieved.

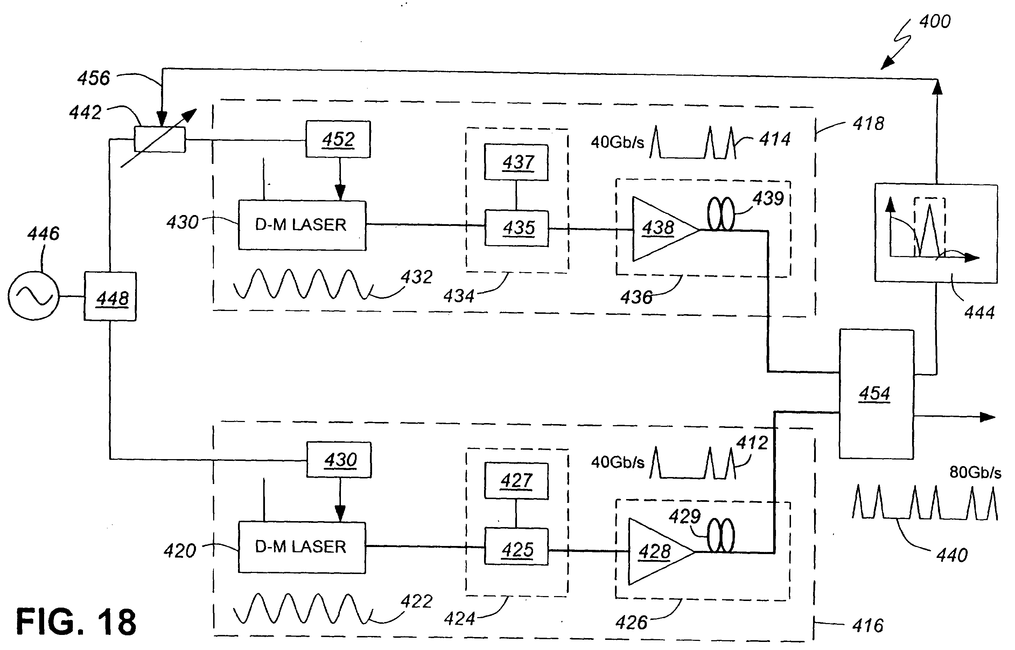

A source **400** of short optical pulse train according to a fifth embodiment of the invention is shown in Figure 18. It comprises means for forming first and second short pulse optical trains **412** and **414** carrying encoded data at frequency $f$, the means including first and second data encoding branches **416** and **418** respectively where the trains **412** and **414** are formed. The first branch **416** includes a first dual mode laser **420** generating a sinusoidal signal **422** at frequency $f$ determined by the beat frequency between the dual modes, first encoding means **424** for encoding data into the laser signal, and a first optical compressor **426** to compress the signal **422** into the first pulse train **412**. The second data encoding branch is same as the first branch and correspondingly includes a second dual mode laser **430** generating a beat signal **432**, second encoding means **434**, and a second optical compressor **436** to compress the signal **432** into the second pulse train **414**. Each of the dual mode lasers **420** and **430** includes two DFB lasers which are similar to that of the first and second DFB lasers **11** and **13** of the first embodiment described above.

Each dual-mode laser operates at a beat frequency of $f$=40 GHz (with a typical range of frequencies $f$ being from 20 GHz to 100 GHz), thus determining the speed requirement for data-encoding means of 40 Gbs/s as well. First and second data-encoding means **424** and **434** respectively include a first electro-optical modulator **425** driven by the first data source **427**, and a second electro-optical modulator **435** driven by the second data source **437**. The first optical compressor **426** includes a first erbium-doped optical fiber amplifier (EDFA) **428** pumped at 980 nm followed by fiber **429** composed of a piece of dispersion shifted fiber (DSF) 4 km long and a piece of a standard single mode fiber (SMF) 1 km long. The DSF is subjected to high optical powers and has high efficiency of providing self-phase modulation, while the SMF, placed after the DSF, uses this nonlinear self-phase modulation generated in the previous fiber section to compress the optical pulse. The second optical compressor **436** has the same structure as the first compressor **426** described above and includes a second EDFA **448** followed by fiber **439**. It is intended to combine two information carrying soliton trains **412** and **414**, each operating at $f$=40 GHz and encoded with data at 40 Gb/s respectively, into one combined short pulse optical train **440** of doubled frequency $f$=80 GHz and carrying information at 80 Gb/s. To do this, means for providing phase shifts between trains **412** and **414** are introduced, including means for subharmonic modulation of the dual mode lasers **420** and **430**, a variable delay line **442** and a feedback means **444**. The means for subharmonic modulation comprises a master microwave source 446 oscillating at frequency $f/n$, (where $n$ is an integer number), whose signal is split in a microwave beam splitter **448** and sent via corresponding bias-tees **450** and **452** to one of the electrodes of each of the dual mode lasers **420** and **430** respectively to achieve subharmonic modulation of the laser beat frequency $f$. Such a subharmonic modulation provides frequency stabilization and phase locking of the beat signals for the dual mode lasers **420** and **430**, effectively reducing frequency jitter and phase noise of the beat signals. The variable delay line **442**, by way of example placed into the second branch **418**, is used to introduce predetermined relative phase shift between the signals generated by the dual mode lasers **420** and **430** so as, when the trains **412** and **414** are further combined in an optical combiner **454**, to interleave and form one combined optical pulse train **440** of frequency $2f$. The optical combiner **454** is a 3dB fiber coupler providing the multiplexing of two trains **412** and **414**. The feedback means **444** is used to provide an active control of the relative phase shift between the branches **416** and **418**. It includes narrow bandwidth photodiode and electrical amplifier (none of them is shown), the amplifier being centralized at frequency $2f$. The feedback means **444** extracts the information about the current phase alignment between the two branches and generates a feedback signal **456** sent to the variable delay line **442**, which is a voltage controlled microwave delay line, to adjust the phase shift between the dual mode lasers **420** and **430** and to ensure that the trains **412** and **414** interleave in precise timing. Since soliton bit trains **412** and **414** are in the return-to-zero (RZ) format, and a distinct feature of RZ signal spectrum is that it has a characteristic peak at the pulse repetition rate, it means that when the two tributary soliton trains **412** and **414** are aligned precisely in timing, the characteristic frequency peak at $2f$ reaches its highest level. Therefore, the measure of the energy at frequency $2f$ indicates the quality of train alignment, and this information is used to control the variable microwave delay line **442**.

Thus, the device **400** for encoding data into a high speed optical train **440** is provided.

The device **400** operates in the following manner. Dual-mode lasers **420** and **430** generate sinusoidal signals **422** and **432** respectively at the beat frequency f=40 GHz between the dual modes. A microwave source **446** oscillating at frequency *f/n*, where *n* is an integer number, subharmonically modulates each of the lasers via bias tees **450** and **452**, thus locking the beat frequency of each laser by the $n^{th}$ harmonic of the microwave source. Since the two lasers are modulated by the same microwave source, the output beat signals from them have a fixed phase relationship. The signals **422** and **432** from the dual mode lasers are encoded with data in data encoding means **424** and **434** respectively and sent to corresponding optical compressors **426** and **436** to compress the sinusoidal optical oscillations **422** and **432** into soliton pulse trains **412** and **414**. After the pulse compression the two information carrying soliton trains **412** and **414** are time domain multiplexed by a fiber coupler **454**. The tunable delay line **442** introduces the required phase shift between the lasers so as to provide interleaving of the trains in precise timing. The feedback means **444** provides an active control of the relative phase shift between the trains by sending the feedback signal **456** to the delay line **442**.

Thus, the soliton pulse train **440** at double frequency *2f* = 80GHz and encoded at 80Gb/s is formed.

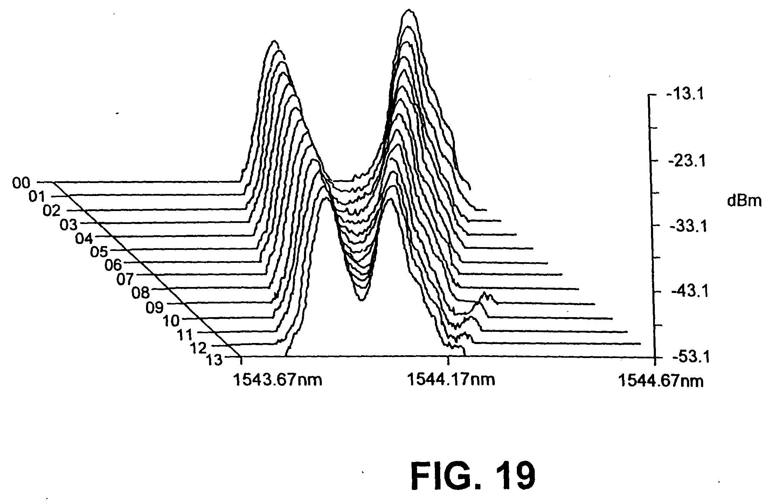

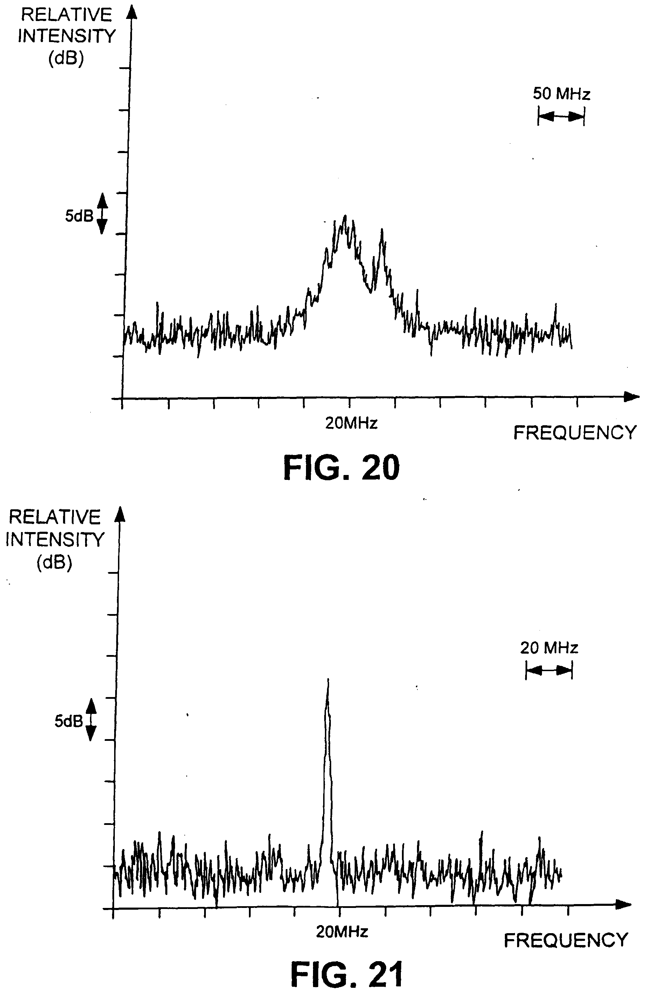

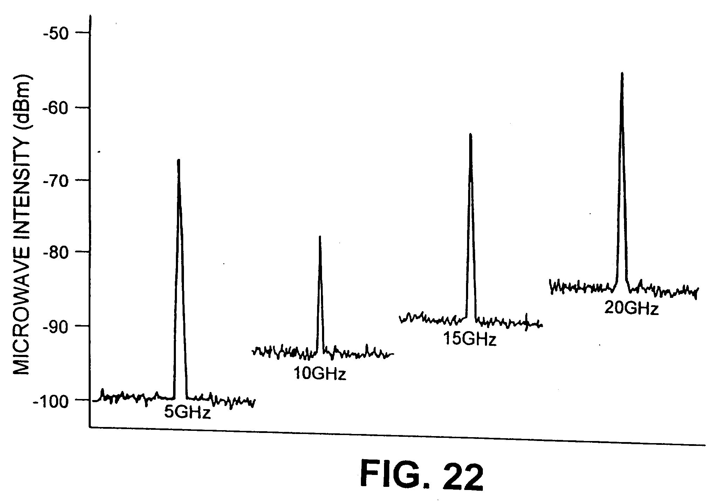

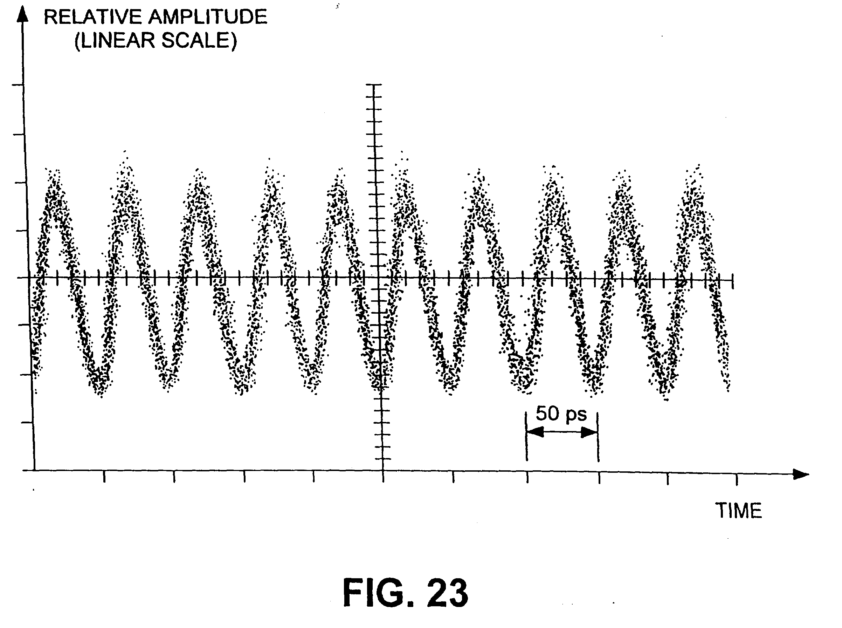

Dual-wavelength operation is obtained by biasing the first and second lasers well above their respective threshold currents. Figure 19 shows a 3-dimensional plot of the optical spectrum of dual-wavelength operation, where the first section is biased at 35mA, and the second section is tuned from about 70mA to about 90mA. As a result, the frequency spacing between the two laser modes is continuously varied from about 18GHz to about 40GHz. Sending this dual-mode lightwave into a high-speed photodiode, the free-running electrical spectrum of the beat signal centered at approximately 20GHz is obtained as shown in Figure 20. Since no special effort is made for the temperature control and optical isolation, the beat frequency is not stable. The linewidth is in the range of several MHz. When a 5GHz radio frequency (RF) signal having power of +9 dBm from the microwave source **446** is used to modulate the first laser, the 20GHz beat signal becomes optically injection locked by the fourth harmonic of the modulation. As shown in Figure 21, the beat frequency is stabilized by the injection locking, and the linewidth is measured to be less than 30Hz, being limited by the stability of the microwave source **446** used and the resolution of the spectrum analyzer. The composite electrical spectrum is shown in Figure 22, where both the fundamental frequency and the harmonics are shown. It is noted that the fourth harmonic of the signal is the strongest, which indicates that the injection locking is quite efficient. Since the injection locked harmonic at the optical beat frequency is much stronger than the fundamental one, a special microwave filter may not be required to use the locked frequency. In order to verify this, the time domain waveform is measured as shown in Figure 23. Apart from the thermal noise of photo detection, it is seen that the time domain response is close to a perfect sinusoidal function, which is stable with little amplitude modulation. This indicates that both the phase noise and time jitter have been significantly reduced, which is important for high bit-rate optical systems. It is worth mentioning that even though we have demonstrated the optical injection locking of one laser, the same master microwave source can simultaneously lock a number of dual-mode lasers in the same way. The beat frequency and phase of every laser in the system is thus synchronized with each other, thus ensuring the stability of their interleaving.

While the device **400** of the fifth embodiment described above has two branches **416** and **418** to combine two short pulse trains **412** and **414** of lower frequency *f* into one combined pulse train **440** of higher frequency 2*f*, the alternative embodiments of the device may include any other number of branches so as to provide corresponding combining of *N* optical trains of frequency *f* into one optical train of frequency *Nf*. The maximum number of branches is determined by the required parameters for the device such as the combined frequency *Nf*, the speed of individual optical modulators, the required accuracy for combining the trains in precise timing. Additionally, having *N* branches would require *N-1* delay lines introduced into *N-1* branches to provide corresponding phase shifts between the trains.

Additional modifications to the device **400** may include substitution of dual-mode DFB lasers having etched through gratings by other known types of lasers which would provide stable operation at the beat frequency. The encoding means **424** and **434** may include electro-optical modulators or other known types of modulators providing the required speed of operation. Preferably, the modulators are electra-absorptive, $LiNbO_3$ or III-V semiconductor material based devices, either Mach-Zehnder or traveling wave type.

In the fifth embodiment described above, the encoding means are disposed so as to encode data into the laser signals before they are compressed in optical compressors. Alternatively, it may be arranged that the data is encoded after compression. The former approach has the following advantages. Encoding data before pulse compression may allow integration of electro-optical modulators together with lasers which would simplify hardware configuration and make the whole device more stable. Another advantage of encoding data before pulse compression is that in this way, the power efficiency of nonlinear pulse compression is 3-dB higher than encoding data after pulse compression. The reason is that after data encoding (on/off key), 50% of the peaks are removed statistically from the periodical waveform and therefore, for a certain average optical power at the fiber amplifier output, the pulse peak power is enhanced by 3-dB.

The means for providing phase shifts between the laser branches may be disposed to provide one of the following configurations: to be disposed so as to introduce phase shifts between the laser signals before encoding and before compressing the signals; or to introduce the phase shifts after encoding and before compressing the signals; or to introduce the phase shifts after compressing the signals and before encoding them with data; or to introduce the phase shifts between the signals after compressing after encoding the signals. Conveniently, the variable delay lines are disposed so as to receive the subharmonically modulated signals. Alternatively, it may be arranged that the means for subharmonic modulation receive laser signals after they are put through the variable delay lines.

Advantageously, the beat frequency $f$ is in the range from about several tens GHz to about several hundred GHz. The duration of pulses in pulse trains is preferably within a range from sub picoseconds to picoseconds.

The source 400 of short pulse optical train described above has the following advantages. Firstly, by using multi-section and/or multi-grating gain coupled DFB lasers, the frequency of each pulse train may be fine tuned to the achievable speed of the existing modulators. Therefore, the device is easily upgradable to the available bandwidth of external modulators. Secondly, as mentioned above, the device may include any required number of lasers forming low frequency pulse trains, being limited only by the repetition rate, the pulse width after compression and the number of interleaved modulators used. Thirdly, a compact long-term wavelength stabilization technology, e.g. using Fabry-Perot etalons, may be additionally used to set and lock frequencies of lasers and making the whole system more stable and reliable.

FABRICATION

Fabrication of the source of short optical pulses 10 according to the first embodiment shown in Fig. 2 proceeds in four stages as follows:

1. first epitaxial growth of substrate and multiple quantum well structure;
2. patterning of the grating structure;
3. second epitaxial growth of the overlying layers;
4. completion of the laser fabricating (e.g. ridge formation, contacts).

The prepared substrate 12 is loaded promptly into a commercially available CVD growth chamber, and a buffer layer 34 of InP followed by the first confinement region 35, including four layers of InGaAsP, is grown. The active medium 14, comprising eight 1% compressively strained P-doped InGaAsP quantum wells 44, separated by seven P-doped InGaAsP unstrained barriers 46, is grown next.

The wafer is then removed from the growth chamber and processed so as to form photo-lithographic gratings 17 and 19 by periodically etched grooves through the active medium 14. First, a dielectric such a $SiO_2$ (not shown) is grown on the surface of the wafer, and the groove pattern is created in the dielectric layer. The grooves are etched using reactive ion etching or wet chemical etching process. The residual dielectric is then removed. Using known crystal growth techniques, for example, a metal oxide chemical vapor deposition, an InP layer 52 is grown in the grooves. Etch stop layer 54 of InGaAsP grown between two buffer layers 56 and 58 of InP, followed by cladding layer 60 of InP and capping layer 62 of InGaAs complete the structure. Source fabrication is then completed using a standard process. For example, to form rectangular ridge waveguides 22 and 24 perpendicular to the grooves of the gratings 17 and 19, a ridge mask is provided on the substrate, and the ridges are formed by etching through the capping layer 62 and top cladding layer 60, the ridges being 2 μm nominal width. The split top electrodes 30 and 32 are defined by the mask used in the metalization step and created in the lift-off process. The output facet 27 of the series is AR-coated (anti-reflection coated). The back facet may be AR-coated, ascleaved or HR-coated (high-reflection coated). Alternatively, after the second regrowth, when a current confining region is formed on the active region, a buried heterostructure may also be grown. A phase mask generated by Electron Beam (EB) lithography or a direct EB writing on wafer may be used as an alternative to a holographic grating printing process for grating formation. The saturable absorber 15 and SOA 23 are formed on the chip simultaneously with the laser structure. The lasers 11 and 13, the absorber 15 and SOA 23 are integrated within same package.

Thus, it will be appreciated that, while specific embodiments of the invention are described in detail above, numerous variations, modifications and combinations of these embodiments fall within the scope of the invention as defined in the following claims.

**Claims**

1. An optical pulse source, comprising:

a first single mode DFB semiconductor laser having a first grating for generating light at a first frequency;
a second single mode DFB semiconductor laser having a second grating for generating light at a second frequency;
the lasers having a common active medium and shared optical path, the lasers providing mutual light injection into each other resulting in generation of a beat signal at a difference frequency of two lasers;

an optical compressor disposed to receive the beat signal and compressing the pulse duration of the signal, thus forming a train of short optical pulses having a pre-determined duration and a repetition rate.

2. A source as defined in claim 1 further comprising a saturable absorber disposed to receive the beat signal before it is received by the compressor, the absorber providing an initial time compression of the signal, thus transforming the beat signal into an initial train of optical pulses.

3. A source as defined in claim 2 further comprising an optical amplifier for amplification the initial train of pulses.

4. A source as defined in claim 1 wherein the optical compressor comprises a dispersion decreasing fiber.

5. A source as defined in claim 1 wherein the optical compressor comprises a dispersion shifted fiber.

6. A source as defined in claim 1 wherein the optical compressor comprises an erbium doped fiber amplifier.

7. A source as defined in claim 3 wherein the optical amplifier comprises an erbium doped fiber amplifier.

8. A source as defined in claim 1 further comprising means for data encoding into the train of short pulses.

9. A source as defined in claim 8 wherein the means for data encoding comprises an optical modulator operating at a speed determined by the repetition rate.

10. A source as defined in claim 1 wherein the repetition rate of the pulse train is from about several tens GHz to about several hundred GHz.

11. A source as defined in claim 1 wherein the repetition rate of the pulse train is from about 20 GHz to about 80 GHz.

12. A source as defined in claim 1 wherein the duration of pulses in the pulse train is within a range from sub picoseconds to picoseconds.

13. A source as defined in claim 1 wherein first and second DFB lasers comprise one of the gain coupled and loss coupled DFB lasers.

14. A source as defined in claim 13 wherein the active medium includes a multiple quantum well structure.

15. A source as defined in claim 14 wherein the first and second gratings are formed by etching grooves directly through the multiple quantum well structure.

16. A source as defined in claim 15 wherein each grating has a period comprising a first section and a second section with substantially all quantum wells being etched away from the second section, thus providing no substantial photon emission in the second section and ensuring no substantial interaction between the lasers.

17. A source as defined in claim 1 further comprising means for stabilizing the frequency of one of the first and second lasers.

18. A source radiation as defined in claim 11 further comprising means for stabilizing the frequencies of both lasers.

19. A source as defined in claim 1 further comprising means for tuning frequencies of the first and second lasers.

20. A source as defined in claim 1 further comprising means for modulating light generated by one of the first and second lasers.

21. A source as defined in claim 20 wherein the modulation is provided at a frequency which is subharmonic to the beat frequency.

22. A source as defined in claim 1 further comprising means for modulating light generated by the lasers simultaneously.

23. A source defined in claim 1 wherein pumping of the active medium is provided by current injection in to the active medium.

24. A source defined in claim 1 wherein pumping of the active medium is provided by an external optical pumping source.

25. A source as defined in claim 1 wherein the first and second gratings have same periods.

26. A source as defined in claim 25 wherein the first and second lasers generate light at the same side of stopband.

27. A source as defined in claim 26 wherein the difference between the first and second frequencies is provided by different current injection into the first and second lasers.

**28.** A source as defined in claim 26 wherein the difference between the first and second frequencies is provided by different width of the active medium in the first and second lasers.

**29.** A source as defined in claim 26 wherein the difference between the first and second frequencies is provided by difference in temperatures at which the first and second lasers are maintained.

**30.** A source as defined in claim 25 wherein the first and second lasers generate light at different sides of stopband.

**31.** A source as defined in claim 1 wherein the first and second gratings have different periods.

**32.** A source as defined in claim 31 wherein the frequency of one of the lasers which is remote from an output facet does not fall within a stopband of the other laser which is closer to the output facet so that light emitted by the remote laser can pass through the shared optical path to the output facet.

**33.** A source as defined in claim 1 wherein the first and second gratings comprise one of the uniform and chirped gratings.

**34.** A source as defined in claim 1 wherein the first and second gratings are first order gratings.

**35.** A source as defined in claim 1 wherein the first and second gratings are formed by one of the holographic writing and electron beam writing onto the active medium.

**36.** An optical pulse source, comprising:

a first single mode DFB semiconductor laser having a first grating for generating light at a first frequency;
a second single mode DFB semiconductor laser having a second grating for generating light at a second frequency;
the lasers having a common active medium and shared optical path, the lasers providing light injection of light into each other resulting in generation of a beat signal at a difference frequency of two lasers;
a saturable absorber disposed to receive the beat signal and providing an initial time compression thus transforming the beat signal into an initial train of optical pulses;
an optical amplifier disposed to receive the initial pulse train after the absorber;
an optical compressor disposed to receive the pulse train after the optical amplifier and compressing duration of pulses of the train, thus forming a train of short optical pulses having a pre-determined duration and a repetition rate,
the first and second lasers, the saturable absorber and the optical amplifier being formed on the same chip.

**37.** A source as defined in claim 36 wherein the first and second lasers, the saturable absorber and the optical amplifier are integrated within a package.

**38.** A source of radiation, comprising:

a first single mode DFB semiconductor laser having a first grating for generating light at a first frequency;
a second single mode DFB semiconductor laser having a second grating for generating light at a second frequency;
the lasers having a common active medium and shared optical path and providing mutual light injection into each other resulting in generation of radiation at a beat frequency of two lasers.

**39.** A source of radiation as defined in claim 38 wherein first and second DFB lasers comprise one of the gain coupled and loss coupled DFB lasers.

**40.** A source of radiation as defined in claim 39 wherein the active medium includes a multiple quantum well structure.

**41.** A source of radiation as defined in claim 40 wherein the first and second gratings are formed by etching grooves directly through the multiple quantum well structure.

**42.** A source of radiation as defined in claim 41 wherein each grating has a period comprising a first section and a second section with substantially all quantum wells being etched away from the second section, thus providing no substantial photon emission in the second section and ensuring no substantial interaction between the lasers.

**43.** A source of radiation as defined in claim 38 wherein the beat frequency corresponds to a wavelength from about microwave to millimeter wavelength range.

**44.** A source as defined in claim 38 wherein the first and second gratings have same periods.

**45.** A source as defined in claim 44 wherein the first and second lasers generate light at the same side of stopband.

**46.** A source as defined in claim 45 wherein the difference between the first and second frequencies is provided by different current injection into the first and second lasers.

47. A source as defined in claim 45 wherein the difference between the first and second frequencies is provided by different width of the active medium in the first and second lasers.

48. A source as defined in claim 45 wherein the difference between the first and second frequencies is provided by difference in temperature control of the first and second lasers.

49. A source as defined in claim 44 wherein the first and second lasers generate light at different sides of stopband.

50. A source as defined in claim 38 wherein the first and second gratings have different periods.

51. A source of radiation as defined in claim 50 wherein the frequency of one of the lasers which is remote from an output facet does not fall within a stopband of the other laser which is closer to the output facet so that light emitted by the remote laser can pass through the shared optical path to the output facet.

52. A source of radiation as defined in claim 38 further comprising means for modulation of light generated by one of the first and second lasers at a frequency subharmonic to the beat frequency.

53. A source of radiation as defined in claim 38 wherein the source is formed on a chip and integrated within a package.

54. A source of short pulse optical train of frequency $Nf$, comprising:

means for forming $N$ short pulse optical trains, each of frequency $f$, carrying encoded data; means for providing phase shifts between said $N$ trains so as, when the trains are combined, to form one combined optical pulse train of frequency $Nf$; means for combining said $N$ trains into said combined optical train.

55. A source as defined in claim 54, wherein the means for forming $N$ short pulse trains comprises:

$N$ data encoding branches, each branch comprising: a dual mode laser generating a signal at frequency $f$ defined by the beat frequency between the dual modes; an optical compressor disposed to receive the laser signal and to compress the duration thereof to form the short pulse train; and encoding means for providing that required data is encoded into the train.

56. A device as defined in claim 55, wherein the means for providing phase shifts between said $N$ trains comprises:

means for subharmonic modulation of each laser at frequency $f/n$, wherein $n$ is an integer, to provide phase locking; variable delay lines disposed to introduce said phase shifts between the signals.

57. A device as defined in claim 56, wherein the means for providing phase shifts further comprises a feedback means for sending control signals to the variable delay lines to adjust the phase shifts so as to ensure that $N$ optical trains interleave in a precise timing.

58. A device as defined in claim 55, wherein the dual mode laser is a DFB laser.

59. A device as defined in claim 55, wherein the dual mode laser comprises first and second DFB lasers, each laser including one of the gain coupled and loss coupled DFB lasers.

60. A device as defined in claim 59, wherein the first and second lasers have common active medium, shared optical path and provide mutual light injection into each other.

61. A device as defined in claim 60, wherein the active medium of the DFB laser includes a multiple quantum well structure.

62. A device as defined in claim 61, wherein the first and second lasers include first and second gratings correspondingly, the gratings being formed by etching grooves directly through the multiple quantum well structure.

63. A device as defined in claim 62, wherein each grating has a period comprising a first section and a second section, with substantially all quantum wells being etched away from the second section, thus providing no substantial photon emission in the second section and ensuring no substantial interaction between the lasers.

64. A device as defined in claim 54, wherein the encoding means comprises an electro-optical modulator.

65. A device as defined in claim 54, wherein the electro-optical modulator is one of the Mach-Zehnder modulator and traveling wave modulator.

**66.** A device as defined in claim 54, wherein *N*=2.

**67.** A device as defined in claim 54, wherein *N*=3.

**68.** A device as defined in claim 54, wherein *N* is in the range from 4 to 10.

**69.** A method for encoding data into high speed optical train, comprising the steps of:

forming *N* short pulse optical trains, each of frequency *f*, carrying encoded data;
providing phase shifts between said *N* trains so as, when the trains are combined, to form one combined optical pulse train of frequency *Nf*;
combining said *N* trains into said combined optical train.

**70.** A method as defined in claim 69, wherein the step of forming *N* short pulse trains comprises the step of forming each of the trains which includes:

providing a dual mode laser generating a signal at frequency *f* defined by the beat frequency between the dual modes;
compressing the signal in the optical compressor to form the short pulse train; and
providing that required data is encoded into the train.

**71.** A method as defined in claim 70, wherein the step of providing phase shifts between the *N* trains comprises:

modulating each laser at frequency *f/n*, which is subharmonic to the beat frequency, to provide phase locking;
forming variable delay lines disposed to introduce said phase shifts between the signals.

PRIOR ART

FIG. 1

EP 1 087 478 A1

FIG. 2

FIG. 3

EP 1 087 478 A1

**FIG. 4**

WAVELENGTH

**FIG. 5**

RELATIVE INTENSITY
(ARBITRARY UNITS)

3.6 ps

# FIG. 6

FIG. 7

FIG. 8

**FIG. 9**

RELATIVE INTENSITY
(ARBITRARY UNITS)

11 ps

# FIG. 10

**FIG. 11**

RELATIVE INTENSITY
(ARBITRARY UNITS)

TIME (4ps/div)

# FIG. 12

RELATIVE INTENSITY
(ARBITRARY UNITS)

TIME (4ps/div)

## FIG. 13

RELATIVE INTENSITY
(ARBITRARY UNITS)

4 ps

# FIG. 14

FIG. 15

**FIG. 16**

EP 1 087 478 A1

FIG. 17

**FIG. 18**

EP 1 087 478 A1

FIG. 19

RELATIVE
INTENSITY
(dB)

50 MHz
|◄—►|

5dB

20MHz

FREQUENCY

**FIG. 20**

RELATIVE
INTENSITY
(dB)

20 MHz
|◄—►|

5dB

20MHz

FREQUENCY

**FIG. 21**

FIG. 22

FIG. 23

**European Patent Office**

## EUROPEAN SEARCH REPORT

Application Number

EP 00 20 2152

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WAKE D ET AL: "OPTICAL GENERATION OF MILLIMETER-WAVE SIGNALS FOR FIBER-RADIO SYSTEMS USING A DUAL-MODE DFB SEMICONDUCTOR LASER" IEEE TRANSACTIONS ON MICROWAVE THEORY AND TECHNIQUES,US,IEEE INC. NEW YORK, vol. 43, no. 9, PART 02, 1 September 1995 (1995-09-01), pages 2270-2276, XP000524215 ISSN: 0018-9480 | 38,43, 44,46, 49,52 | H01S5/12 H01S5/10 |
| A | * page 2271, paragraph 2 - page 2272, paragraph 3; figure 2 * | 54,69 | |
| X | LIMA C R ET AL: "COMPACT OPTICAL MILLIMETRE-WAVE SOURCE USING A DUAL-MODE SEMICONDUCTOR LASER" ELECTRONICS LETTERS,GB,IEE STEVENAGE, vol. 31, no. 5, 2 March 1995 (1995-03-02), pages 364-365, XP000498180 ISSN: 0013-5194 | 38,43, 44,46, 49,52 | |
| A | * the whole document * | 54,69 | TECHNICAL FIELDS SEARCHED (Int.Cl.7) |
| A | DE 195 13 198 A (HERTZ INST HEINRICH) 2 October 1996 (1996-10-02) * column 4, line 36 - column 5, line 56; figure 2 * | 38,54,69 | H01S |
| A | WO 98 10544 A (ERICSSON TELEFON AB L M) 12 March 1998 (1998-03-12) * page 5, line 2 - page 6, line 10; figure 1 * | 38,54,69 | |

The present search report has been drawn up for all claims

| Place of search | Date of completion of the search | Examiner |
|---|---|---|
| THE HAGUE | 5 January 2001 | Hervé, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 00 20 2152

This annex lists the patent family members relating to the patent documents cited in the above-mentioned European search report.
The members are as contained in the European Patent Office EDP file on
The European Patent Office is in no way liable for these particulars which are merely given for the purpose of information.

05-01-2001

| Patent document cited in search report | | Publication date | Patent family member(s) | | Publication date |
|---|---|---|---|---|---|
| DE 19513198 | A | 02-10-1996 | WO | 9630976 A | 03-10-1996 |
| | | | DE | 59602877 D | 30-09-1999 |
| | | | EP | 0818069 A | 14-01-1998 |
| | | | JP | 11502676 T | 02-03-1999 |
| | | | US | 6122306 A | 19-09-2000 |
| WO 9810544 | A | 12-03-1998 | SE | 507376 C | 18-05-1998 |
| | | | AU | 4140697 A | 26-03-1998 |
| | | | CN | 1237298 A | 01-12-1999 |
| | | | EP | 1010281 A | 21-06-2000 |
| | | | SE | 9603219 A | 05-03-1998 |

For more details about this annex : see Official Journal of the European Patent Office, No. 12/82